# EUROPEAN PATENT APPLICATION

(11) **EP 4 697 688 A1**
(43) Date of publication of application: **18.02.2026**
(21) Application number: 25195529.0
(22) Date of filing: 12.08.2025
(51) Int. Cl.: H04M 1/02, G06F 1/16, G09F 9/30, H10K 77/10, H10K 102/00

(54) **DISPLAY DEVICE AND METHOD OF MANUFACTURING THE SAME**

(30) Priority: 16.08.2024 KR 20240109765
(71) Applicant: Samsung Display Co., Ltd., Yongin-si, Gyeonggi-do 17113 (KR)
(72) Inventor: KIM, Younggon, 17113 Yongin-si (KR); KOO, Bonjoo, 17113 Yongin-si (KR); PARK, Joo-Young, 17113 Yongin-si (KR); YOO, Je Yoon, 17113 Yongin-si (KR); JUNG, Taehyun, 17113 Yongin-si (KR)
(74) Representative: Marks & Clerk LLP

(57) **Abstract**

A display device including: a display panel including a first region, a second region, and a bendable region between the first region and the second region; a bending protective layer disposed on the bendable region; a window disposed on the display panel and overlapping the first region; and a window protective layer disposed on the window and including an extension portion overlapping the bending protective layer, wherein the window protective layer and the display panel have the same cutting line in a portion of an overlapping region where the window protective layer overlaps the display panel.

## Description

### 1. Technical Field

Embodiments of the disclosure relate to a display device and a method of manufacturing the display device.

### 2. Description of the Related Art

Display devices are designed to visually present data. They typically include a substrate that is divided into a display region and a non-display region. The display region contains multiple pixel regions, each equipped with a thin-film transistor (TFT) and a pixel electrode electrically connected to the TFT. These components correspond to the individual pixel regions. The non-display region includes various conductive layers, such as interconnections that transmit electrical signals to the display region.

In such display devices, visibility from various angles may be improved or the area of the non-display region may be reduced by bending at least a portion of the device. For example, a display panel may be designed so that a portion of the non-display region surrounding the display region is folded, positioning that part of the non-display region behind the display panel. This configuration helps minimize the dead space of the display device. The folded portion of the display panel is referred to as a bent region.

In addition, the display device itself is flexible, allowing the shape of at least a portion of the display device to be altered. Such flexible display devices can be categorized based on their purpose or form, including bendable, foldable, rollable, and stretchable display devices.

### SUMMARY

Embodiments of the disclosure provide a display device having improved aesthetics and minimized tolerance between components.

Additional aspects will be set forth in portion in the description which follows and, in part, will be apparent from the description, or may be learned by practice of the presented embodiments of the disclosure.

An embodiment of the disclosure provides a display device including: a display panel including a first region, a second region, and a bendable region between the first region and the second region; a bending protective layer disposed on the bendable region; a window disposed on the display panel and overlapping the first region; and a window protective layer disposed on the window and including an extension portion overlapping the bending protective layer, wherein the window protective layer and the display panel have the same cutting line in a portion of an overlapping region where the window protective layer overlaps the display panel.

The cutting line of the window protective layer corresponding to the extension portion aligns with the cutting line of the display panel.

The cutting line of the window protective layer corresponding to the extension portion aligns with a cutting line of the bending protective layer.

A portion of the cutting line extending from the first region to the second region includes a curve.

The cutting line of the window protective layer and a cutting line of the bending protective layer have the same curvature.

The window protective layer is separated from the bending protective layer.

A length of the extension portion is less than an inner radius of the bendable region.

A length of the extension portion is greater than an outer radius of the bendable region.

A length of the window protective layer is greater than a length of the window, and the window exposes the extension portion of the window protective layer.

The window does not overlap the bendable region.

The window protective layer includes a light blocking region adjacent to an edge of the window.

The light blocking region overlaps the bendable region.

A cutting line of the light blocking region aligns with a cutting line of the bending protective layer.

An embodiment of the disclosure provides a method of manufacturing a display device, the method including: preparing a display panel including a first region, a second region, and a bendable region between the first region and the second region; disposing a bending protective layer on the bendable region; disposing a window overlapping the first region on the display panel; disposing a window protective layer including an extension portion overlapping the bending protective layer on the window; and forming the window protective layer and the display panel to have the same cutting line in an overlapping region where the window protective layer overlaps the display panel.

In the forming of the window protective layer and the display panel to have the same cutting line, the window protective layer and the display panel are integrally cut while in a joined state.

The forming of the window protective layer on the window is performed after the window is formed on the display panel.

The forming of the window on the display panel is performed after the window protective layer is formed on the window.

In the forming of the window protective layer and the display panel to have the same cutting line, the cutting line of the window protective layer formed in the extension portion and a cutting line of the bending protective layer coincide with each other.

In the forming of the window protective layer and the display panel to have the same cutting line, the window protective layer and the display panel are cut so that a cutting line formed in the bendable region includes a curved portion.

The window protective layer includes a light blocking region adjacent to an edge of the window, and a cutting line of the light blocking region coincides with a cutting line of the bending protective layer.

An embodiment of the disclosure provides an electronic device including a display device, wherein the display device includes: a display panel including a first region, a second region, and a bendable region between the first region and the second region; a bending protective layer disposed on the bendable region; a window disposed on the display panel and overlapping the first region; and a window protective layer disposed on the window and including an extension portion overlapping the bending protective layer, wherein the window protective layer and the display panel have the same cutting line in a portion of an overlapping region where the window protective layer overlaps the display panel.

At least some of the above and other features of the invention are set out in the claims.

### BRIEF DESCRIPTION OF THE DRAWINGS

The above and other features of certain embodiments of the disclosure will become more apparent from the following description taken in conjunction with the accompanying drawings, in which:
FIG. 1 is a perspective view schematically illustrating a display device according to an embodiment of the disclosure.
FIGS. 2 and 3 are perspective views illustrating the display device of FIG. 1 in a folded state.
FIG. 4 is a plan view of a display panel according to an embodiment of the disclosure.
FIG. 5 is a circuit diagram schematically illustrating a display element provided in one pixel of a display device and a pixel circuit connected thereto according to an embodiment of the disclosure.
FIG. 6 is a cross-sectional view schematically illustrating an example of a cross-section taken along line I-I' of a display panel illustrated in FIG. 4.
FIG. 7 is a cross-sectional view schematically illustrating another example of a cross-section taken along line I-I' of the display panel illustrated in FIG. 4.
FIG. 8 is a cross-sectional view of the display device taken along line II-II' of FIG. 4.
FIG. 9 is a cross-sectional view illustrating a portion of the display device of FIG. 8 in a bent state.
FIG. 10 is a plan view schematically illustrating a portion of a display device corresponding to portion III of FIG. 4.
FIG. 11 is an enlarged view of portion A of FIG. 10.
FIG. 12 is a plan view of a display device cut along a cutting line of FIG. 11.
FIG. 13 is a view illustrating a comparative example of FIG. 12.
FIG. 14 is a cross-sectional view schematically illustrating a window protective layer according to an embodiment of the disclosure.
FIG. 15 is a cross-sectional view schematically illustrating a window protective layer according to another embodiment of the disclosure.
FIG. 16 is a cross-sectional view schematically illustrating a portion of an electronic device to which a display device according to a comparative example is applied.
FIGS. 17 and 18 are cross-sectional views schematically illustrating a portion of an electronic device to which a display device according to an embodiment of the disclosure is applied.
FIG. 19 is a flowchart schematically illustrating a method of manufacturing a display device according to an embodiment of the disclosure.
FIG. 20 is a flowchart schematically illustrating a method of manufacturing a display device according to another embodiment of the disclosure.

### DETAILED DESCRIPTION OF THE EMBODIMENTS

Reference will now be made in detail to embodiments, examples of which are illustrated in the accompanying drawings, wherein like reference numerals denote like elements throughout. It should be understood that the present embodiments may have different forms and should not be construed as being limited to the descriptions set forth herein. As used herein, the term "and/or" includes any and all combinations of one or more of the associated listed items. Expressions, such as "at least one of," when preceding a list of elements, apply to the entire list rather than modifying the individual elements of the list.

In the following embodiments, terms, such as "first," "second," etc. are used to distinguish one component from another and are not intended to imply any order, priority, or limitation.

In the following examples, singular terms include plural terms unless the context clearly dictates otherwise.

In the following embodiments, the terms such as "including" "having," and "comprising" are intended to indicate the existence of the features or components disclosed in the specification, and are not intended to preclude the possibility that one or more other features or components may exist or may be added.

In the following embodiments, when a unit, area, component, or similar part is described as being "on" or "over" another part, this includes both cases where it is directly on top of the other part and cases where other units, areas, components, or similar elements are interposed between them.

In the following embodiments, terms, such as connecting or combining, do not necessarily mean a direct and/or fixed connection or combination of two members, unless the context clearly indicates otherwise. Additionally, these terms do not exclude that another member is interposed between the two members.

In the drawings, the sizes of components may be exaggerated or reduced for convenience of description. For example, the size and/or thickness of each component shown in the drawings are arbitrarily shown for convenience of description. Therefore, the following embodiments are not necessarily limited to that which is shown.

In addition, terms such as "below," "lower," "above," and "upper" are used to describe the relationships between components illustrated in the drawings. The terms are relative and based on the orientations shown in the drawings. As used herein, "disposed on" may refer to being disposed on top of, as well as below, one of the elements.

Throughout the specification, the term "in plan view" refers to viewing a target element from above, while "in cross-sectional view", refers to viewing a vertically taken section of a target element from the side.

This disclosure aims to improve the design and functionality of display devices with bent regions by introducing a window protective layer WPL that overlaps with a bending protective layer BPL and aligning their cutting lines through a precise Laser Full-Shape Cut (LFC) process. This approach enhances aesthetics by reducing visible decorative elements and improves lamination tolerance in the overlapping areas. The optimized overlap between the window protective layer WPL and the bending protective layer BPL minimizes exposed areas after bending, resulting in a cleaner, more reliable display panel design.

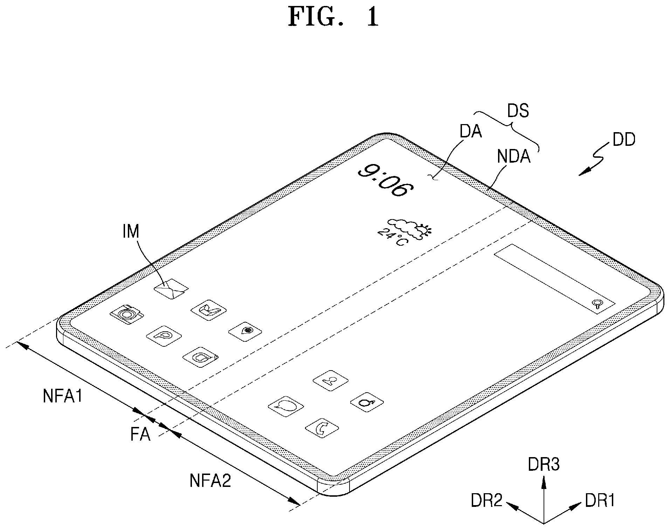

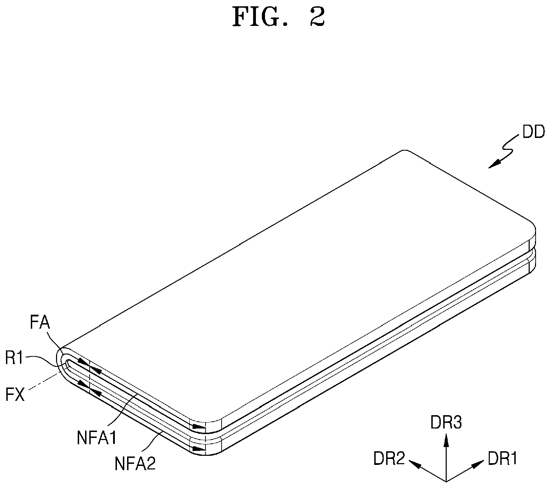

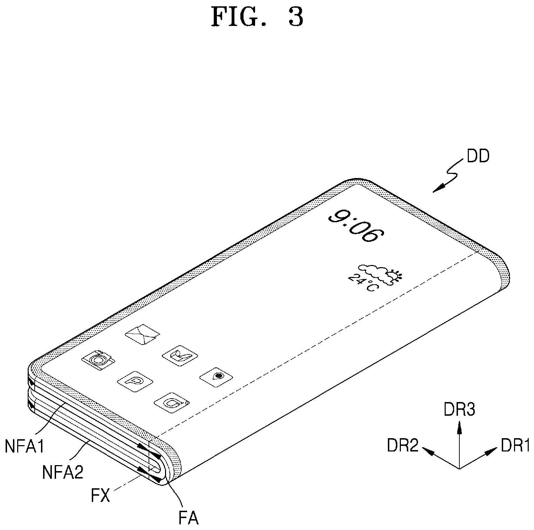

FIG. 1 is a perspective view schematically illustrating a display device DD according to an embodiment of the disclosure, and FIGS. 2 and 3 are perspective views illustrating the display device DD of FIG. 1 in a folded state.

Referring to FIGS. 1 to 3, the display device DD according to an embodiment may be a device activated by an electrical signal. In FIG. 1, the display device DD is illustrated as a mobile phone, but the present disclosure is not limited thereto.

The display device DD according to an embodiment may include a display surface DS formed in a first direction DR1 and a second direction DR2 intersecting the first direction DR1. Images IM generated in the display device DD may be displayed to a user through the display surface DS.

Hereinafter, a direction substantially perpendicular to planes formed in the first direction DR1 and the second direction DR2 is referred to as a third direction DR3. The third direction DR3 is a reference for distinguishing the front (e.g., upper surface) and rear (e.g., lower surface) of each member. In this specification, "in a plane" refers to a state observed along the third direction DR3.

The display device DD according to an embodiment may include a display region DA and a non-display region NDA outside the display region DA. In FIG. 1, the display region DA is illustrated as having a rectangular shape, but the present disclosure is not limited thereto. The display region DA may be provided in various shapes, such as a circle, ellipse, and polygon.

The display region DA is an area that displays an image, and a plurality of pixels PX may be arranged in the display region DA. Hereinafter, in this specification, a "pixel" may refer to a "sub-pixel. " Each pixel PX may include a light emitting element, such as an organic light emitting diode (OLED). Each pixel PX may emit light of, for example, red, green, blue or white.

The display region DA may provide an image through light emitted from the pixels PX. As described above, a pixel PX in this specification may be a light emitting region that emits light of any one of red, green, blue, or white.

The non-display region NDA is a region in which pixels PX are not present and may be a region that does not provide an image. A printed circuit board including a power supply wiring and a driving circuit for driving the pixels PX or a terminal portion to which a driver IC is connected may be disposed in the non-display region NDA.

Hereinafter, an organic light emitting display device is described as an example of the display device DD according to an embodiment. However, the display device DD according to an embodiment is not limited thereto. The display device DD according to an embodiment may be a display device, such as an inorganic light emitting display (or inorganic electro luminescence (EL) display) or a quantum dot light emitting display. For example, a light emitting layer included in a light emitting element provided in the display device DD may include an organic material or an inorganic material. Additionally, quantum dots may be located along a path of light emitted from the light emitting layer.

In addition, the display device DD according to an embodiment may be applied to various products, such as a portable electronic device, e.g., a mobile phone, a smartphone, a tablet personal computer (PC), a mobile communication terminal, an electronic notebook, an electronic book, a portable multimedia player (PMP), a navigation device, and an ultra mobile PC (UMPC), as well as a television, a laptop, a monitor, a billboard, and an Internet of Things (IOT) device. In addition, the display device DD according to an embodiment may be applied to wearable devices, such as a smart watch, a watch phone, a glasses-type display, and a head mounted display (HMD). In addition, the display device DD according to an embodiment may be applied to a dashboard of a vehicle, a center information display (CID) located on a center fascia or dashboard of a vehicle, a rearview mirror display replacing a side mirror of a vehicle, and a display screen disposed on the back of a front seat as entertainment for a rear seat of a vehicle.

The display device DD may include a folded region FA and a plurality of unfolded regions NFA1 and NFA2. For example, the unfolded regions NFA1 and NFA2 may include a first unfolded region NFA1 and a second unfolded region NFA2. The folded region FA may be located between the first unfolded region NFA1 and the second unfolded region NFA2. The folded region FA, the first unfolded region NFA1, and the second unfolded region NFA2 may be arranged in the second direction DR2.

As illustrated in FIG. 2, the folded region FA may be folded about a folding axis FX parallel to the first direction DR1. The folded region FA has a predetermined curvature and radius of curvature R1. The first unfolded region NFA1 and the second unfolded region NFA2 face each other, allowing the display device DD to be folded inward such that the display surface DS is not exposed externally.

As illustrated in FIG. 3, the folded region FA may be folded outward exposing the display surface DS externally along the folding axis FX, which is parallel to the first direction DR1.

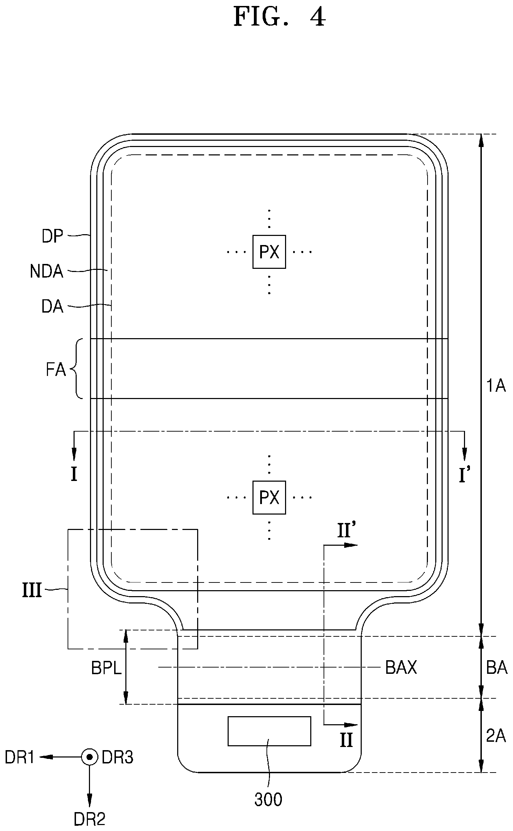

FIG. 4 is a plan view of a display panel DP according to an embodiment of the disclosure.

The display panel DP includes a display region DA capable of displaying an image and a non-display region NDA located around the display region DA. Here, the display region DA and the non-display region NDA correspond to the display region DA and the non-display region NDA of the display device DD (see FIG. 1), respectively.

The display panel DP includes a bent region BA and a first region 1A and a second region 2A located at both sides of the bent region BA.

From another perspective, the display panel DP includes the bent region BA located between the first region 1A and the second region 2A.

The display region DA is located in the first region 1A. The second region 2A may be located apart from the first region 1A, and a driving unit 300 of the display region DA may be located in the second region 2A. The driving unit 300 may be in the form of a chip-on-film (COF) or a printed circuit board and may supply a driving signal to the display region DA to drive the display device DD.

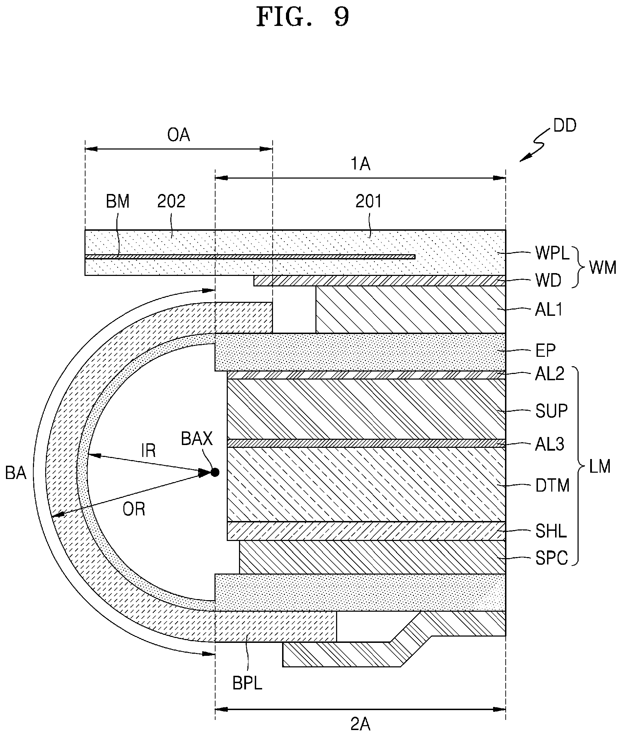

The display panel DP may be bent in the bent region BA. This bending occurs along a bending axis BAX, which is parallel to the first direction DR1. When the display panel DP bent, the first region 1A and the second region 2A may face each other and overlap in the third direction DR3, which is perpendicular to the plane formed by the intersection of the first direction DR1 and the second direction DR2, as illustrated in FIG. 9.

The display device DD according to an embodiment may also include a bending protective layer BPL disposed on an upper surface of the display panel DP. The bending protective layer BPL may overlap a portion of the bent region BA and the surrounding first region 1A. The bending protective layer BPL may also overlap a portion of the second region 2A adjacent to the bent region BA.

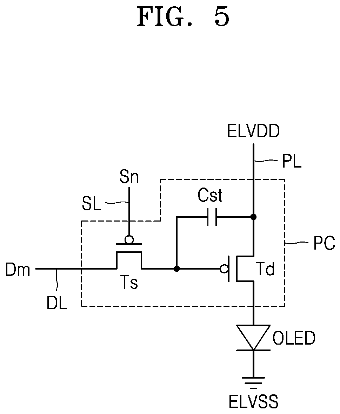

FIG. 5 is a circuit diagram schematically illustrating a display element provided in one pixel of a display device and a pixel circuit connected thereto according to an embodiment of the present disclosure.

Referring to FIG. 5, each pixel PX may include a pixel circuit PC connected to a scan line SL and a data line DL and an OLED connected to the pixel circuit PC.

The pixel circuit PC may include a driving thin film transistor (TFT) Td, a switching TFT Ts, and a storage capacitor Cst. The switching TFT Ts may be connected to the scan line SL and the data line DL and may transmit a data signal Dm input through the data line DL to the driving TFT Td according to a scan signal Sn input through the scan line SL.

The storage capacitor Cst may be connected to the switching TFT Ts and a driving voltage line PL, and may store a voltage corresponding to a difference between a voltage received from the switching TFT Ts and a first power supply voltage ELVDD supplied to the driving voltage line PL or the driving voltage.

The driving TFT Td may be connected to the driving voltage line PL and the storage capacitor Cst and may control a driving current flowing through the OLED from the driving voltage line PL in response to the voltage stored in the storage capacitor Cst. The OLED may emit light with a certain brightness depending on the driving current. An opposite electrode (e.g., a cathode) of the OLED may be configured to receive a second power supply voltage ELVSS.

In FIG. 5, a case in which the pixel circuit PC includes two TFTs and one storage capacitor is illustrated, but the present disclosure is not limited thereto. In another embodiment, the pixel circuit PC may include, for example, seven TFTs and one storage capacitor. In another embodiment, the pixel circuit PC may include two or more storage capacitors.

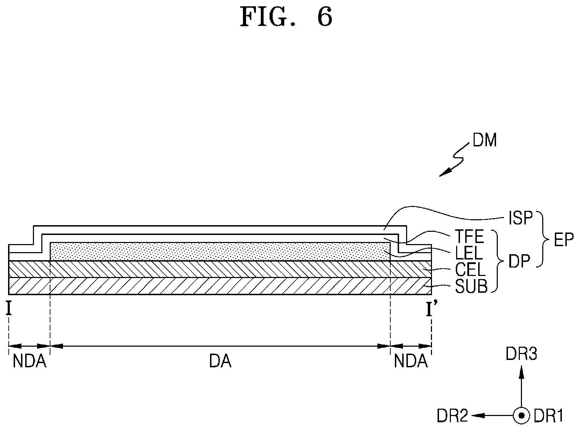

FIG. 6 is a cross-sectional view schematically illustrating an example of a cross-section taken along line I-I' of a display panel illustrated in FIG. 4.

Referring to FIG. 6, a display module DM of an embodiment may include an electronic panel EP. The electronic panel EP may include a display panel DP and an input sensor ISP disposed on the display panel DP. The display panel DP may include a base layer SUB, a circuit layer CEL disposed on the base layer SUB, a light emitting element layer LEL disposed on the circuit layer CEL, and a thin film encapsulation layer TFE disposed on the light emitting element layer LEL.

The base layer SUB may provide a base surface on which the circuit layer CEL is disposed. The base layer SUB may be a flexible substrate capable of bending, folding, rolling, etc. The base layer SUB may be a glass substrate, a metal substrate, or a polymer substrate. However, the present disclosure is not limited thereto, and the base layer SUB may be an inorganic layer, an organic layer, or a composite material layer.

The circuit layer CEL may be disposed on the base layer SUB. The circuit layer CEL may include insulating layers, transistors each including a semiconductor pattern, circuit wiring connected to the transistors, and conductive patterns.

The circuit layer CEL may be disposed on the base layer SUB. The circuit layer CEL may include insulating layers, transistors each including a semiconductor pattern, circuit interconnections connected to the transistors, and conductive patterns.

The light emitting element layer LEL may be disposed on the circuit layer CEL. The light emitting element layer LEL may include a light emitting element. For example, the light emitting element may include an organic light emitting material, an inorganic light emitting material, an organic-inorganic light emitting material, a quantum dot, a quantum rod, a micro LED, or a nano LED.

The thin film encapsulation layer TFE may be disposed on the light emitting element layer LEL. The thin film encapsulation layer TFE may protect the light emitting element layer LEL from foreign substances, such as moisture, oxygen, and dust particles. The thin film encapsulation layer TFE may include at least one inorganic layer. The thin film encapsulation layer TFE may include a stack structure of inorganic layer/organic layer/inorganic layer.

The input sensor ISP may include a plurality of electrodes for detecting an external input, trace lines connected to the plurality of electrodes, and an organic layer and/or inorganic layer for insulating/protecting the plurality of electrodes or trace lines. The input sensor ISP may be a capacitive sensor but is not particularly limited thereto.

The input sensor ISP may be disposed directly on the display panel DP. The display panel DP and input sensor ISP may be formed through a sequential process. Therefore, a separate adhesive layer may not be located between the input sensor ISP and the display panel DP.

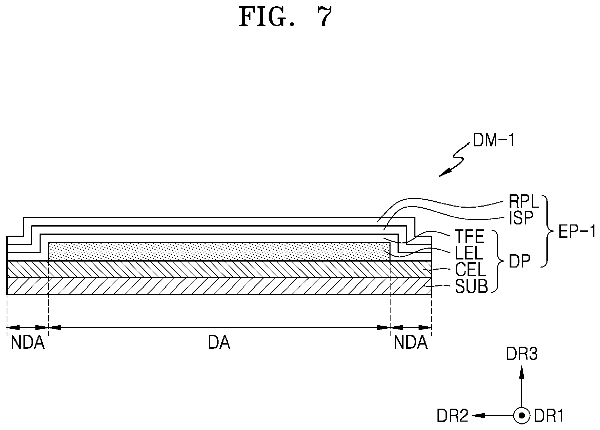

FIG. 7 is a cross-sectional view schematically illustrating another example of a cross-section taken along line I-I' of the display panel illustrated in FIG. 4.

Referring to FIG. 7, a display module DM-1 according to an embodiment may further include an anti-reflection layer RPL.

The anti-reflection layer RPL may be disposed directly on the input sensor ISP. The anti-reflection layer RPL may reduce the reflectance of external light incident from the outside of the display device DD (see FIG. 1).

The anti-reflection layer RPL may include an optical film to reduce the reflectance of external light. For example, the anti-reflection layer RPL may include a phase retarder and/or a polarizer. The anti-reflection layer RPL may include a polarizing film.

Alternatively, the anti-reflection layer RPL may include color filters arranged in a specific pattern. For example, the arrangement of the color filters may be determined based on the emission colors of pixels included in the display panel DP. In addition, the anti-reflection layer RPL may further include a black matrix adjacent to the color filters.

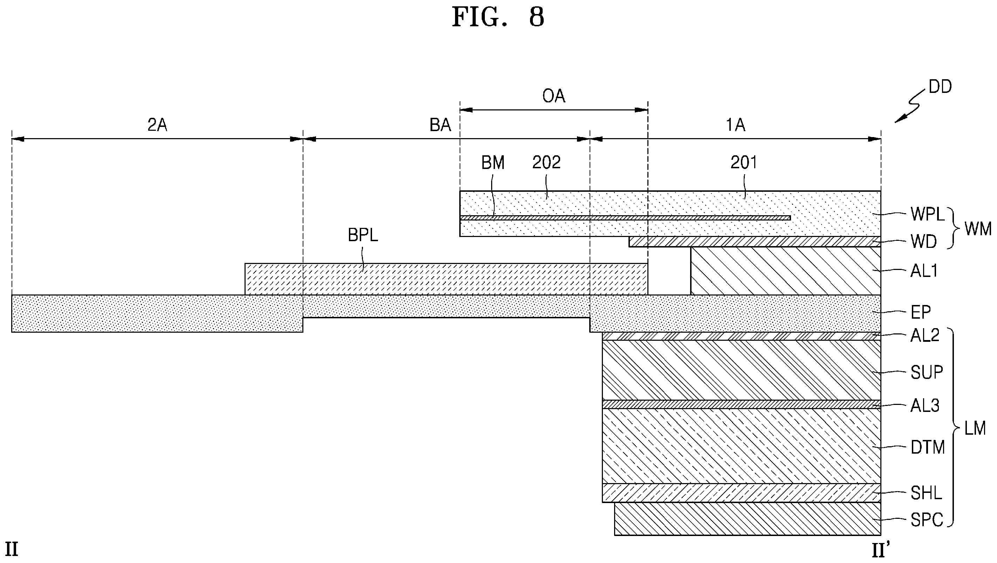

FIG. 8 is a cross-sectional view of the display device taken along line II-II' of FIG. 4, and FIG. 9 is a cross-sectional view illustrating a portion of the display device of FIG. 8 in a bent state.

In FIG. 8, a cross-section of an electronic panel EP corresponding to II-II' and a cross-section of a window module WM are shown together.

Referring to FIGS. 8 and 9, the display device DD may include the electronic panel EP, the bending protective layer BPL, a lower module LM, and the window module WM.

The electronic panel EP may be the electronic panel EP illustrated in FIG. 6. The electronic panel EP may, similarly to the display panel DP, include the first region 1A, the second region 2A, and the bent region BA between the first region 1A and the second region 2A.

The bending protective layer BPL may include a portion located on an outer surface of the bent region BA, a portion located on an upper surface of the first region 1A, and a portion located on a lower surface of the second region 2A when the bent region BA of the display panel DP is bent, and these portions may be formed continuously with each other. For example, the portion located on the outer surface of the bent region BA may be referred to as a first portion of the bending protective layer BPL, the portion located on the upper surface of the first region 1A may be referred to as a second portion of the bending protective layer BPL, and the portion located on a lower surface of the second region 2A may be referred to as a third portion of the bending protective layer BPL. When the bent region BA of the display panel DP is bent, the second and third portions may face each other. A first end of the bending protective layer BPL and an edge thereof may be located on the first region 1A of the display panel DP adjacent to the bent region BA, and a second end of the bending protective layer BPL and an edge thereof may be located on the second region 2A of the display panel DP adjacent to the bent region BA. The bending protective layer BPL may cover at least a portion of the boundary between the bent region BA and the first region 1A and the boundary between the bent region BA and the second region 2A.

The bending protective layer BPL may be bent together with the bent region BA. The bending protective layer BPL located on the bent region BA may reduce tensile or compressive stress applied to the bent region BA by raising a neutral plane when the bent region BA is bent, thereby reducing damage to the interconnection of the bent region BA.

The window module WM may be disposed on the electronic panel EP to protect the electronic panel EP.

However, the present disclosure is not limited thereto. The window module WM may alternately be described as being positioned on the display module DM, which includes the electronic panel EP.

The window module WM may include a window WD and a window protective layer WPL disposed on the window WD.

The window WD may protect the electronic panel EP from external scratches. The window WD may have optically transparent properties. The window WD may include glass. For example, the window WD may include a thin film glass substrate. However, without being limited thereto, the window WD may include a synthetic resin film.

The window protective layer WPL may have a multilayer structure. This will be described in detail below. The window protective layer WPL may include a flexible plastic material, such as polyimide or polyethylene terephthalate.

The window module WM may include a printed layer BM. In detail, the printed layer BM may be included in the window protective layer WPL. Alternatively, the printed layer BM may be disposed on one surface of a thin film glass substrate or one surface of the window protective layer WPL.

The printed layer BM may be black, but the color of the printed layer BM is not limited thereto. In a planar view, the printed layer BM may be located adjacent to the edge of the window protective layer WPL.

The window protective layer WPL may include a main portion 201 and an extension portion 202. Here, the extension portion 202 may overlap the bending protective layer BPL. In detail, the extension portion 202 may overlap the bending protective layer BPL on the bent region BA.

The window protective layer WPL may extend from the first region 1A to the bent region BA.

In other words, the window protective layer WPL may overlap the first region 1A and the bending protective layer BPL.

In addition, as illustrated in FIG. 9, the window protective layer WPL may be spaced apart from the bending protective layer BPL. In detail, the window protective layer WPL and the bending protective layer BPL may overlap along the thickness direction of the display device DD. However, a first adhesive layer AL1 is positioned on the electronic panel EP, with the window module WM placed on top of the first adhesive layer AL1. This configuration ensures that the window protective layer WPL does not come into direct contact with the bending protective layer BPL.

A length of the extension portion 202 may be less than an inner radius IR of the bent region BA. Here, the inner radius IR of the bent region BA may be a distance from the bending axis BAX to a lower surface of the electronic panel EP.

Alternatively, the length of the extension portion 202 may be greater than an outer radius OR of the bent region BA.

From another perspective, the length of the extension portion 202 may be greater than a distance from the bending axis BAX to an upper surface of the bending protective layer BPL.

From another perspective, when the display panel DP is bent in the bent region BA, a tangent line of the bent region BA corresponding to the third direction DR3 may intersect the extension portion 202.

Therefore, when the display device DD is viewed on a plane, the bending protective layer BPL may be covered by the window protective layer WPL.

Furthermore, a length of the window protective layer WPL is greater than a length of the window WD, allowing the window WD to expose the extension portion 202 of the window protective layer WPL.

In other words, the window WD may be disposed in the first region 1A and may not overlap the bent region BA.

The first adhesive layer AL1 may be located between the window module WM and the electronic panel EP. In other words, the window protective layer WPL may be bonded to the window WD by the first adhesive layer AL1.

The display device DD may further include the lower module LM disposed below the electronic panel EP.

The lower module LM may include a support plate SUP, a digitizer DTM, a shielding layer SHL, a spacer SPC, and second and third adhesive layers AL2 and AL3.

The support plate SUP may be disposed below the electronic panel EP to support the electronic panel EP. The second adhesive layer AL2 may be located between the electronic panel EP and the support plate SUP. In other words, the electronic panel EP may be bonded to the support plate SUP by the second adhesive layer AL2.

In addition, the rigidity of the support plate SUP may be greater than that of the electronic panel EP.

The digitizer DTM may be disposed below the support plate SUP. In detail, the third adhesive layer AL3 may be located between the support plate SUP and the digitizer DTM.

The digitizer DTM is a device that may receive location information indicated by a user on a display surface. The digitizers DTM may be implemented in an electromagnetic manner (or electromagnetic resonance manner). For example, the digitizer DTM may include a digitizer sensor substrate including a plurality of coils. However, without being limited thereto, the digitizer DTM may also be implemented in an active electrostatic manner.

For example, the digitizer DTM may detect input from an electromagnetic pen. In this case, the digitizer DTM may detect input from an electromagnetic pen by using electromagnetic resonance (EMR).

The shielding layer SHL may be disposed below the digitizer DTM. The shielding layer SHL may include metal. For example, the shielding layer SHL may include copper, but the metal material of the shielding layer SHL is not limited thereto.

The shielding layer SHL may shield electromagnetic fields that may be applied to the digitizer DTM below the display device DD. The shielding layer SHL may also be referred to as an electromagnetic shielding layer. The shielding layer SHL including metal may act as a heat dissipation layer.

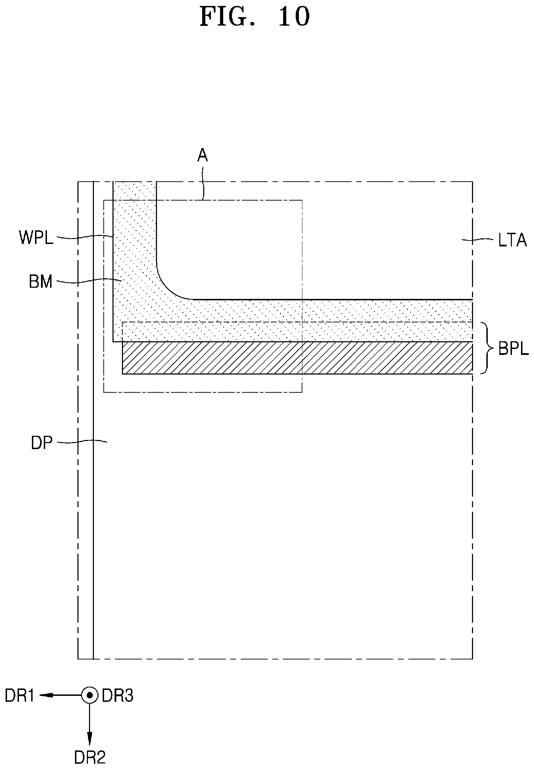

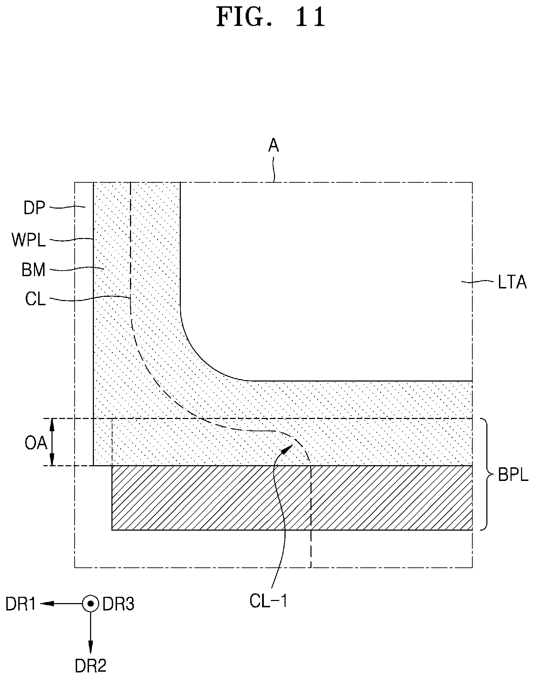

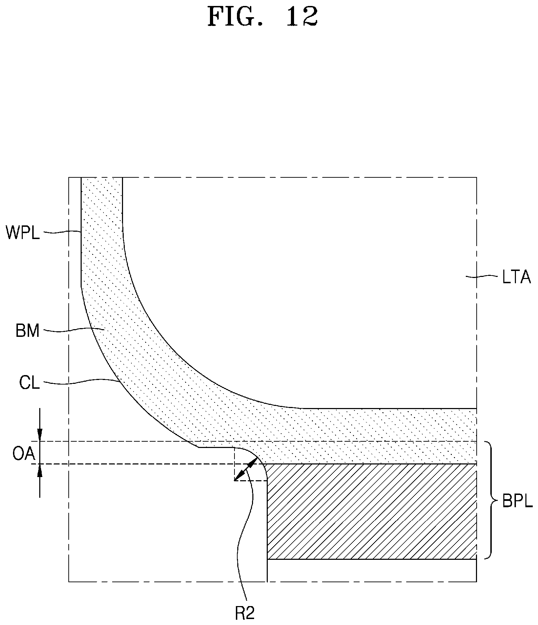

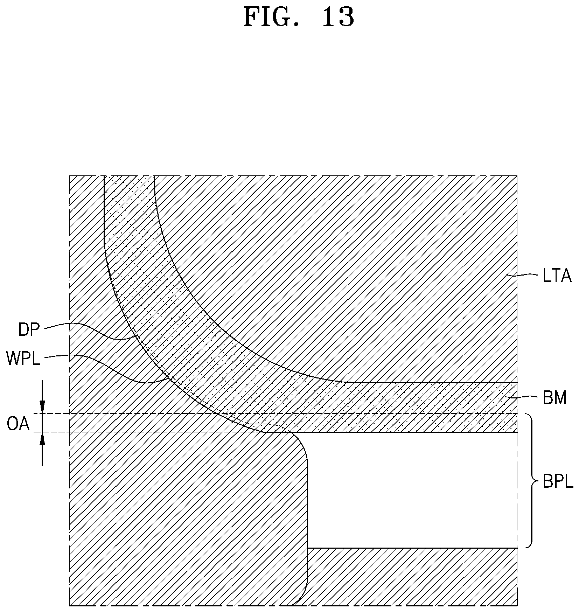

FIG. 10 is a plan view schematically illustrating a portion of a display device corresponding to portion III of FIG. 4, and FIG. 11 is an enlarged view of portion A of FIG. 10. FIG. 12 is a plan view of a display device cut along a cutting line of FIG. 11, and FIG. 13 is a view illustrating a comparative example of FIG. 12.

FIG. 10 illustrates a state before cutting the display panel. FIG. 11 is a view illustrating a cutting line on the display panel and the bending protective layer.

Referring to FIGS. 10 to 12, the window module of the display device according to an embodiment may be cut together with the display panel, while being joined together.

As described above, the bending protective layer BPL may be disposed on a portion of the upper surface of the display panel DP. In detail, the bending protective layer BPL may be disposed in the bent region BA and the adjacent first region 1A and second region 2A.

The window protective layer WPL may include a light transmitting region LTA and a light blocking region BM. Here, the light blocking region BM may correspond to the printed layer BM.

As illustrated in FIG. 10, the window WD and the window protective layer WPL may be arranged on the display panel DP. Additionally, the window protective layer WPL may overlap a portion of the bending protective layer BPL in the bent region BA.

The display panel DP may be cut together with the window module WM. In other words, the window protective layer WPL and the display panel DP may be cut together using an integrated cutting method.

Here, a virtual cutting line for cutting the window protective layer WPL and the display panel DP is referred to as a cutting line CL. In the display device according to an embodiment, a shape of the display panel DP may be processed by irradiating the cutting line CL with a laser or by using a cutter.

The cutting line CL may be formed adjacent to the edge of the window module WM. For example, the cutting line CL may be formed on the light blocking region BM.

The display panel DP and the window module WM may include a curved portion in a corner region between the first region 1A and the bent region BA in a plan view.

The cutting line CL may extend from the first region 1A to the second region 2A through the bent region BA. Additionally, the cutting line CL, which extends from the first region 1A to the second region 2A, may include a curved portion CL-1.

Referring to FIG. 12, the window module WM and the display panel DP, when cut through integral cutting, may have cutting lines CL that coincide (e.g., align) with each other.

In other words, the window protective layer WPL and the display panel DP may share the same cutting line CL in at least a portion of the overlapping region where the window protective layer WPL overlaps the display panel DP.

In detail, the cutting line CL of the window protective layer WPL corresponding to the extension portion 202 may coincide with the cutting line CL of the display panel DP.

In detail, because the window protective layer WPL overlaps the bending protective layer BPL in the overlapping region OA, the cutting line CL of the window protective layer WPL corresponding to the extension portion 202 may align with the cutting line CL of the bending protective layer BPL.

The cutting line CL extending from the first region 1A to the second region 2A may also include the curved portion CL-1 in the overlapping region OA.

Here, the cutting line CL of the window protective layer WPL and the cutting line CL of the bending protective layer BPL may have the same curvature. In other words, the curved portion of the cutting line CL of the window protective layer WPL and the curved portion of the cutting line CL of the bending protective layer BPL may have the same radius of curvature R2.

In addition, the cutting line CL of the light blocking region BM may coincide with the cutting line CL of the bending protective layer BPL.

In a comparative example illustrated in FIG. 13, the cutting line of the display panel DP does not coincide with the cutting line of the window protective layer WPL, unlike the display device DD according to an embodiment illustrated in FIG. 12.

For example, while a lower edge of the window protective layer WPL in FIG. 13 is straight, the display panel DP and the bending protective layer BPL may include a curved portion.

In the comparative example, within the overlapping region OA, the display panel DP and the bending protective layer BPL are cut as a single piece, resulting in coinciding cutting lines. However, the window protective layer WPL is not cut together with the bending protective layer BPL. As a result, the cutting lines of the window protective layer WPL and the bending protective layer BPL may not align. Similarly, the cutting lines of the window protective layer WPL and the display panel DP may also not align.

In other words, when the display panel DP is processed by laser cutting and subsequently joined the window module WM, a tolerance may arise between the display panel DP and the window module WM.

In contrast, in the display device DD according to an embodiment, integral laser cutting is performed after the display panel DP and the window module WM are joined, effectively eliminating tolerance. Specifically, the window protective layer WPL is laser-cut to share the same cutting line as the display panel DP and the bending protective layer BPL. This prevents the window protective layer WPL from protruding beyond the edges of the display panel DP and minimizes the occurrence of tolerance.

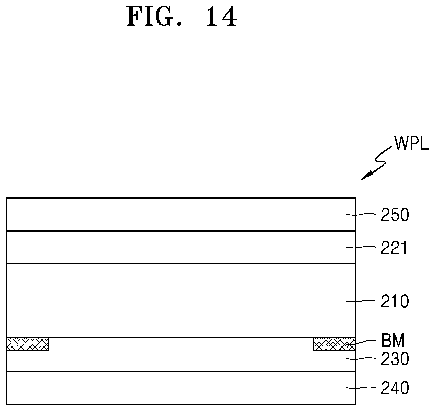

FIG. 14 is a cross-sectional view schematically illustrating the window protective layer WPL according to an embodiment of the present disclosure.

The window WD may have a multilayer structure or a single-layer structure. For example, the window WD may include a plurality of synthetic resin films bonded with an adhesive or may include a glass substrate and a synthetic resin film bonded with an adhesive.

Referring to FIG. 14, the window protective layer WPL according to an embodiment may include a main film 210, a functional layer 221, an adhesive layer 230, a first protective film 240, and a second protective film 250.

The window protective layer WPL may be disposed on the window WD. The window protective layer WPL may include a flexible plastic material, such as polyimide or polyethylene terephthalate. A hard coating layer may be disposed on an upper surface of the window protective layer WPL.

The window protective layer WPL may include the light blocking region BM disposed on a lower surface facing the adhesive layer 230.

The second protective film 250 may be a protective film that is thicker than the first protective film 240. In other words, the second protective film 250 disposed on the functional layer 221 may be thicker than the first protective film 240 disposed below the adhesive layer 230.

The functional layer 221 may include at least one of a hard coating layer, an anti-fingerprint layer, or an anti-reflection layer.

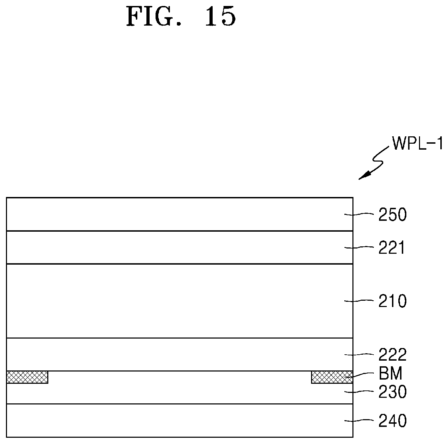

FIG. 15 is a cross-sectional view schematically illustrating a window protective layer WPL-1 according to another embodiment.

The window protective layer WPL-1 illustrated in FIG. 15 may further include a functional layer 222 on the adhesive layer 230, compared to the window protective layer WPL illustrated in FIG. 14. In other words, the functional layer 222 may be disposed below the main film 210.

The functional layer 222 may be a film that supplements the rigidity of the main film 210 and has higher rigidity than the main film 210.

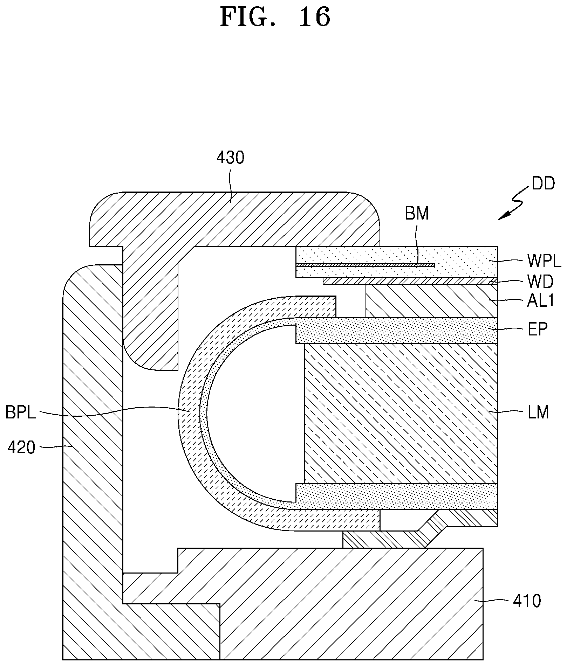

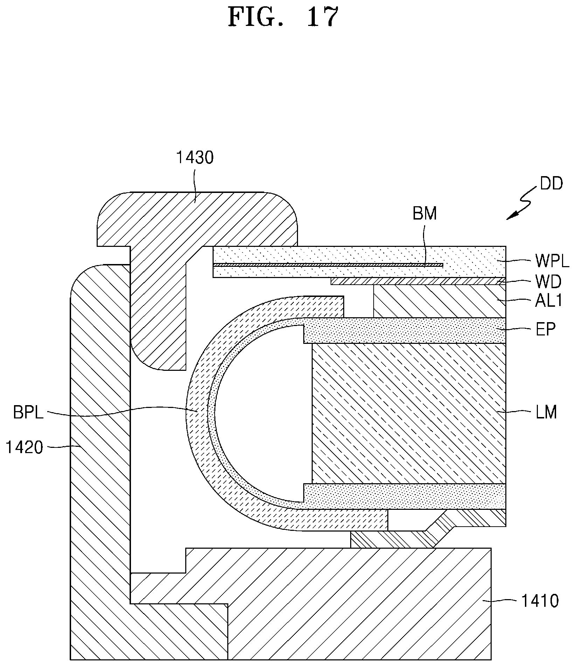

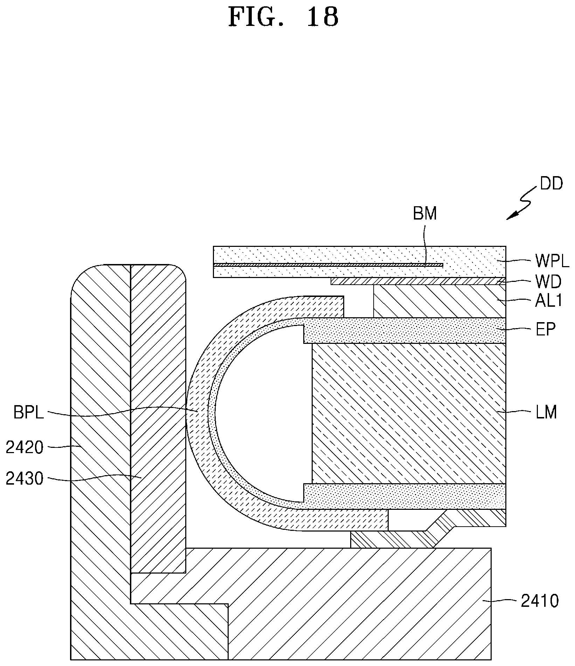

FIG. 16 is a cross-sectional view schematically illustrating a portion of an electronic device to which a display device according to a comparative example is applied. FIGS. 17 and 18 are cross-sectional views schematically illustrating a portion of an electronic device to which a display device according to an embodiment of the disclosure is applied.

The electronic device according to a comparative example may include a first housing 410 supporting a lower portion of the display device DD, a second housing 420 supporting a side surface of the display device DD, and a third housing 430 located above the bent region BA. In other words, when viewed in a plan view, the third housing 430 may be a component positioned along the periphery of the display device DD, contributing to the overall appearance of the display device DD.

Here, a first side of the third housing 430 may be connected to the second housing 420, and a second side of the third housing 430 may be connected to the window protective layer WPL. In other words, the second side of the third housing 430 may be in contact with an upper surface at one end of the window protective layer WPL.

Referring to FIG. 16, the window protective layer WPL according to the comparative example does not include the extension portion 202. That is, because the window protective layer WPL does not overlap the bent region BA, the bent region BA is exposed.

Accordingly, when the display device DD in the comparative example is assembled with the housing, the third housing 430 may extend over the window protective layer WPL to cover the exposed bent region BA. In other words, the third housing 430 may extend beyond the bent region BA into the first region 1A.

Referring to FIG. 17, the window protective layer WPL according to an embodiment may include the extension portion 202 extending to the bent region BA. This allows the bent region BA to be covered by the window protective layer WPL. Therefore, a third housing 1430 may be formed to extend only to the extension portion 202 of the window protective layer WPL. In other words, the third housing 1430 does not need to extend into the first region 1A, allowing its length to be reduced. In FIG. 17, elements 1410 and 1420 respectively refer to the first and second housings.

In addition, referring to FIG. 18, in the display device DD according to an embodiment, the bent region BA may be sufficiently covered by the window protective layer WPL. As a result, a third housing 2430 applied to this embodiment of the display device DD may be designed without an upper portion. Specifically, in the third housing 2430, the upper region extending beyond the bent region BA toward the first region 1A may be omitted.

By reducing or eliminating the third housing 430 located adjacent to the bent region BA of the display device DD, the openness of the display device DD may be increased, enhancing its aesthetic appearance. In FIG. 18, elements 2410 and 2420 respectively refer to the first and second housings.

Hereinafter, a method of manufacturing a display device according to an embodiment is described.

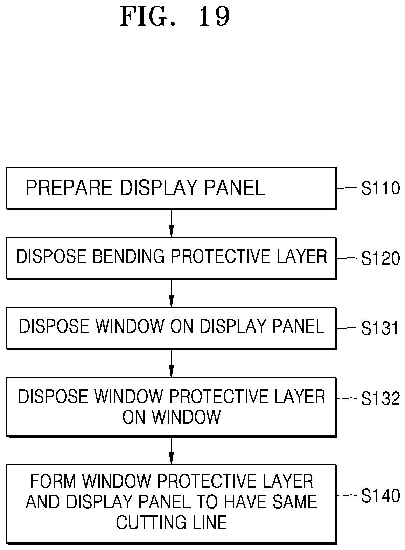

FIG. 19 is a flowchart schematically illustrating a method of manufacturing a display device according to an embodiment of the disclosure.

Referring to FIG. 19, a method of manufacturing a display device according to an embodiment includes an operation of preparing the display panel (S110), an operation of disposing the bending protective layer (S120), an operation of disposing the window on the display panel (S131), an operation of disposing the window protective layer on the window (S132), and an operation of forming the window protective layer and the display panel to have the same cutting line (S140).

The operation of preparing the display panel (S110) may be an operation of preparing the electronic panel EP in which the first region 1A, the bent region BA, and the second region 2A are provided. The first region 1A may include the folded region FA, the first unfolded region NFA1, and the second unfolded region NFA2.

The electronic panel EP may include at least the display panel DP (see FIG. 6). Hereinafter, the description of the electronic panel EP may be equally applied to the display panel DP (see FIG. 6).

From another perspective, the operation of preparing the display panel (S110) is an operation of preparing the display panel DP including the first region 1A, the second region 2A apart from the first region 1A, and the bent region BA between the first region 1A and the second region 2A.

The operation of disposing the bending protective layer BPL (S120) involves placing the bending protective layer BPL on the bent region BA. In other words, this operation entails positioning the bending protective layer BPL (S120) on the display panel DP corresponding to the bent region BA.

The operation of disposing the window on the display panel (S131) involves placing the window WD to overlap the first region 1A of the display panel DP. Referring to FIG. 8, the first adhesive layer AL1 may be located between the window WD and the display panel DP. In other words, the first adhesive layer AL1 is applied to the display panel DP and the window WD is disposed on the first adhesive layer AL1, thereby bonding the window WD to the display panel DP.

The operation of disposing the window protective layer WPL on the window WD (S132) involves placing the window protective layer WPL, including the extension portion 202 that overlaps the bending protective layer BPL, onto the window WD.

The operation of forming the window protective layer WPL on the window WD (S132) may be performed after the window WD is formed on the display panel DP.

As described above with reference to FIG. 8 and so on, because the window protective layer WPL is longer than the window WD, the window WD may partially expose the window protective layer WPL.

As illustrated in FIG. 10, the window protective layer WPL is disposed on the display panel DP, with the extension portion 202 of the window protective layer WPL overlapping the bending protective layer BPL.

Referring to FIG. 14, the adhesive layer 230 of the window protective layer WPL may face the window WD, allowing the window protective layer WPL to adhere to the window WD.

The operation of forming the window protective layer WPL and the display panel DP with the same cutting line in the overlapping region (S140) involves performing integral cutting on the window protective layer WPL while it is joined to the display panel DP.

In other words, the window module WM, which includes the window WD and the window protective layer WPL, is first disposed on the display panel DP. Then, the window module WM and the display panel DP are laser-cut together.

In this process, the cutting line of the window protective layer WPL formed in the extension portion 202 may align with the cutting line of the bending protective layer BPL.

The operation of forming the window protective layer WPL and the display panel DP with the same cutting line in the overlapping region (S140) involves cutting the window protective layer WPL and the display panel DP so that the cutting line CL formed in the bent region BA includes the curved portion CL-1.

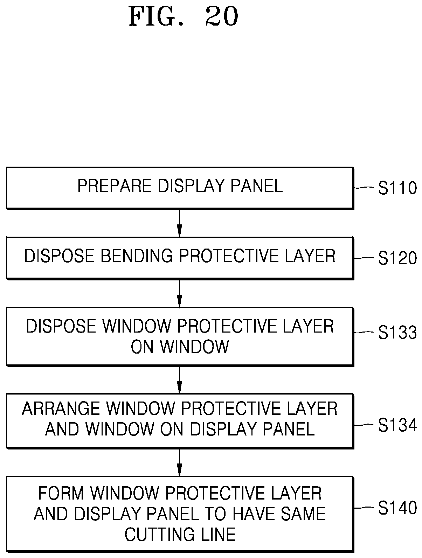

FIG. 20 is a flowchart schematically illustrating a method of manufacturing a display device according to another embodiment of the disclosure.

Referring to FIG. 20, the method of manufacturing a display device according to another embodiment may include an operation of preparing the display panel (S110), an operation of disposing the bending protective layer (S120), an operation of disposing the window protective layer on the window (S133), an operation of arranging the window protective layer and the window on the display panel (S134), and an operation of forming the window protective layer and the display panel to have the same cutting line (S140).

In the present embodiment, the operation of preparing the display panel (S110), the operation of disposing the bending protective layer (S120), and the operation of forming the window protective layer and the display panel to have the same cutting line (S140) are the same as the operations of the embodiment described above with reference to FIG. 19.

As illustrated in FIG. 20, the operation of arranging the window protective layer WPL and the window WD on the display panel DP (S134) is performed after forming the window protective layer WPL on the window WD (S133).

In this embodiment, the process sequence involves joining the window protective layer WPL and the window WD to first prepare the window module WM. The window module WM is then disposed on the display panel DP.

In this configuration, with the window WD and the window protective layer WPL sequentially arranged on the display panel DP, the window protective layer WPL and the display panel DP are integrally cut to share the same cutting line. Specifically, the window protective layer WPL and the bending protective layer BPL are integrally cut to have the same cutting line in the overlapping region where the window protective layer WPL overlaps the bending protective layer BPL.

Each of the embodiments described above may be implemented independently, but the structure of each embodiment may be applied in combination to other embodiments.

In the specification of the embodiment (particularly in the claims), the use of the terms "a" and "an" and "the" and similar referents may be construed to cover both the singular and the plural. Lastly, the steps of all methods described herein may be performed in any suitable order unless explicitly stated otherwise or clearly contradicted by the context. The embodiments are not necessarily limited by the order in which the steps are described above.

According to an embodiment, the aesthetics of a display device may be improved and the tolerance between components may be minimized.

However, these effects are examples and the effects of the present disclosure are not limited thereto.

Embodiments described herein are intended to be illustrative, not restrictive. Features or aspects within each embodiment should be considered potentially applicable to other similar embodiments. While specific embodiments have been depicted in the figures, those skilled in the art will recognize that variations in form and details may be made without departing from the scope set forth by the following claims.

## Claims

1. A display device (DD) comprising:
a display panel (DP) including a first region (1A), a second region (2A), and a bendable region (BA) between the first region (1A) and the second region (2A);
a bending protective layer (BPL) disposed on the bendable region (BA);
a window (WD) disposed on the display panel (DP) and overlapping the first region (1A); and
a window protective layer (WPL) disposed on the window (WD) and including an extension portion (202) overlapping the bending protective layer (BPL),
wherein the window protective layer (WPL) and the display panel (DP) have the same cutting line (CL) in a portion of an overlapping region (OA) where the window protective layer (WPL) overlaps the display panel (DP).

2. The display device (DD) of claim 1, wherein
the cutting line (CL) of the window protective layer (WPL) corresponding to the extension portion (202) aligns with the cutting line (CL) of the display panel (DP).

3. The display device (DD) of claim 2, wherein
the cutting line (CL) of the window protective layer (WPL) corresponding to the extension portion (202) aligns with a cutting line (CL) of the bending protective layer (BPL).

4. The display device (DD) of any one of claims 1 to 3, wherein
a portion of the cutting line (CL) extending from the first region (1A) to the second region (2A) includes a curve (CL-1), optionally wherein
the cutting line (CL) of the window protective layer (WPL) and a cutting line (CL) of the bending protective layer (BPL) have the same curvature (R2).

5. The display device (DD) of any one of claims 1 to 4, wherein
the window protective layer (WPL) is separated from the bending protective layer (BPL).

6. The display device (DD) of any one of claims 1 to 5, wherein
a length of the extension portion (202) is less than an inner radius (IR) of the bendable region (BA).

7. The display device (DD) of any one of claims 1 to 5, wherein
a length of the extension portion (202) is greater than an outer radius (OR) of the bendable region (BA), optionally wherein
a length of the window protective layer (WPL) is greater than a length of the window (WD), and the window (WD) exposes the extension portion (202) of the window protective layer (WPL).

8. The display device (DD) of any one of claims 1 to 7, wherein
the window (WD) does not overlap the bendable region (BA).

9. The display device (DD) of any one of claims 1 to 8, wherein
the window protective layer (WPL) includes a light blocking region (BM) adjacent to an edge of the window (WD).

10. The display device (DD) of claim 9, wherein
the light blocking region (BM) overlaps the bendable region (BA), optionally wherein
a cutting line (CL) of the light blocking region (BM) aligns with a cutting line (CL) of the bending protective layer (BPL).

11. A method of manufacturing a display device (DD), the method comprising: preparing a display panel (DP) including a first region (1A), a second region (2A), and a bendable region (BA) between the first region (1A) and the second region (2A);
disposing a bending protective layer (BPL) on the bendable region (BA);
disposing a window (WD) overlapping the first region (1A) on the display panel (DP);
disposing a window protective layer (WPL) including an extension portion (202) overlapping the bending protective layer (BPL) on the window (WD); and
forming the window protective layer (WPL) and the display panel (DP) to have the same cutting line (CL) in an overlapping region (OA) where the window protective layer (WPL) overlaps the display panel (DP).

12. The method of claim 11, wherein,
in the forming of the window protective layer (WPL) and the display panel (DP) to have the same cutting line (CL), the window protective layer (WPL) and the display panel (DP) are integrally cut while in a joined state.

13. The method of claim 12, wherein:
(i) the forming of the window protective layer (WPL) on the window (WD) is performed
after the window (WD) is formed on the display panel (DP); or
(ii) the forming of the window (WD) on the display panel (DP) is performed after the window protective layer (WPL) is formed on the window (WD).

14. The method of any one of claims 11 to 13, wherein:
(i) in the forming of the window protective layer (WPL) and the display panel (DP) to have the same cutting line (CL),
the cutting line (CL) of the window protective layer (WPL) formed in the extension portion (202) and a cutting line (CL) of the bending protective layer (BPL) coincide with each other; and/or
(ii) in the forming of the window protective layer (WPL) and the display panel (DP) to have the same cutting line (CL),
the window protective layer (WPL) and the display panel (DP) are cut so that a cutting line (CL) formed in the bendable region (BA) includes a curved portion (CL-1); and/or
(iii) the window protective layer (WPL) includes a light blocking region (BM) adjacent to an edge of the window (WD), and
a cutting line (CL) of the light blocking region (BM) coincides with a cutting line (CL) of the bending protective layer (BPL).

15. An electronic device comprising a display device (DD),
wherein the display device (DD) includes:
a display panel (DP) including a first region (1A), a second region (2A), and a bendable region (BA) between the first region (1A) and the second region (2A);
a bending protective layer (BPL) disposed on the bendable region (BA);
a window (WD) disposed on the display panel (DP) and overlapping the first region (1A); and
a window protective layer (WPL) disposed on the window (WD) and including an extension portion (202) overlapping the bending protective layer (BPL),
wherein the window protective layer (WPL) and the display panel (DP) have the same cutting line (CL) in a portion of an overlapping region (OA) where the window protective layer (WPL) overlaps the display panel (DP).
